# DEMANDE DE BREVET EUROPEEN

(11) **EP 1 180 718 A1**
(43) Date de publication de la demande: **20.02.2002**
(21) Numéro de dépôt: 00202834.8
(22) Date de dépôt: 11.08.2000
(51) Int. Cl.: G03B 17/12, G03B 17/28, G03B 29/00, H04N 1/031, H04N 5/225

(54) **Appareil de prise d'images de petites dimensions, notamment appareil photographique ou caméra**

(71) Demandeur: EM Microelectronic-Marin SA, 2074 Marin (CH)
(72) Inventeur: Doering, Elko, 2572 Mörigen (CH); Grupp, Joachim, 2073 Enges (CH); Pfefferli, Beat, 2075 Thielle-Wavre (CH)
(74) Mandataire: Surmely, Gérard

(57) **Abrégé**

L'appareil de prise d'images (3) de petites dimensions comprend un capteur (4) et des lentilles de focalisation (8, 9, 10, 11) agencés dans un châssis (12). Le capteur est agencé à une première face (16) du substrat (18) qui présente une ouverture (20) en regard de laquelle est agencée la surface photosensible (6) de ce capteur. De l'autre côté, à la deuxième face (22) du support (18) est agencé le châssis de l'objectif de manière que les lentilles soient sensiblement alignées avec l'ouverture du support et la surface photosensible.

## Description

La présente invention concerne un appareil de prise d'images de petites dimensions, notamment un appareil photographique ou une caméra, dans lequel il est prévu un capteur formé d'une pluralité de pixels servant à la détection d'images. Cet appareil comprend au moins une lentille de focalisation dont l'axe optique croise sensiblement le centre géométrique de la surface photosensible du capteur.

En particulier, l'appareil de prise de vue selon l'invention est destiné à être incorporé dans un dispositif portable multifonctionnel, notamment un téléphone mobile, une montre ou un micro-ordinateur portable.

Le document EP 0 935 162 décrit un appareil de prise d'images de ce type qui comprend un objectif formé d'un châssis dans lequel sont logées des lentilles de focalisation et d'un capteur ou dispositif optoélectronique qui est agencé directement à l'arrière de l'objectif, du côté de la surface photosensible. La fixation de l'objectif directement sur le capteur du côté de la surface photosensible présente plusieurs inconvénients. Premièrement, les dimensions du capteur doivent être sensiblement égales à celles de l'objectif à son extrémité interne du côté du capteur. Deuxièmement, un tel agencement pose des problèmes pour la connexion électrique des différents pixels aux unités de traitement des signaux électriques fournis par ces pixels qui sont situés au niveau de la surface photosensible sur laquelle est fixé le châssis de l'objectif. D'ailleurs, l'agencement de la connexion électrique du capteur aux unités électroniques de traitement de ces signaux électriques n'est pas divulguée dans ce document. En particulier, un support du type PCB agencé au dos du capteur sera nécessaire, ce qui augmente la hauteur de l'appareil.

Un autre inconvénient majeur du dispositif décrit ci-dessus vient du fait que le capteur est fragilisé par le fait qu'il sert directement de support pour l'objectif. Quand bien même le châssis de l'objectif peut être maintenu par des moyens qui lui sont propres, des éléments électroniques de traitement et d'exploitation des signaux électriques reçus par le capteur doivent être mécaniquement associés à ce dernier. Dans cette réalisation, le capteur forme donc un élément intermédiaire entre le châssis de l'objectif et diverses unités électroniques par exemple situées sur un support commun à ces unités et au capteur comprenant les plages de contact et les pistes de liaison électrique. Le capteur est donc soumis à des contraintes mécaniques néfastes, ce qui peut facilement le détériorer notamment lorsqu'il s'agit d'un capteur intégré dans une plaquette semiconducteur. Pour rigidifier ce capteur et protéger la surface photosensible de celui-ci, il est possible de loger ce capteur dans un boîtier comprenant un lame transparente au-dessus de cette surface photosensible, le châssis de l'objectif étant alors fixé à ce boîtier. Une telle solution augmente la hauteur et l'encombrement de l'appareil de prise d'images. De plus, il augmente son coût de fabrication.

Un but de la présente invention est de pallier les inconvénients mentionnés ci-dessus en fournissant un appareil de prise d'images ayant des dimensions minimales et qui soit facilement intégrable dans un dispositif portable, notamment un téléphone mobile ou une montre.

Un autre but de l'invention est de fournir un tel appareil dans lequel le capteur est protégé de contraintes mécaniques notamment liées au support et à la fixation du châssis de l'objectif logeant des lentilles de focalisation.

Un autre but de l'invention est de fournir un appareil de prise d'images de petites dimensions dans lequel les connexions électriques entre les pixels du capteur et les unités électroniques de traitement et/ou d'exploitation des signaux électroniques fournis par ces pixels sont aisément établies lors de la fabrication de cet appareil et ne soit pas fragile.

Finalement, un autre but de l'invention est de fournir un tel appareil qui soit compact et d'assemblage aisé pour une production peu onéreuse.

A cet effet, l'invention concerne un appareil de prise d'images de petites dimensions formé d'au moins une lentille optique et d'un capteur présentant une surface photosensible sensiblement centrée sur l'axe optique de la lentille, cet appareil étant caractérisé en ce que le capteur est monté à une première face d'un support qui présente une ouverture, ladite surface photosensible étant située en regard de cette ouverture, ladite lentille optique étant agencée du côté du support opposé à ladite première face.

Selon des caractéristiques particulières de l'invention, le support comprend des premières plages de contact électrique correspondant à des deuxièmes plages ou bornes du capteur agencées du côté de la surface photosensible, c'est-à-dire du côté où sont agencés les pixels. Ce support comprend aussi des pistes conductrices permettant de relier électriquement la partie photosensible du capteur aux autres unités électroniques périphériques servant au traitement et à l'exploitation des signaux électriques reçus.

Dans un mode de réalisation préféré qui sera décrit ci-après, il est prévu qu'au moins une partie des lentilles formant l'objectif de l'appareil sont agencées dans un châssis en forme de tube ouvert à ses deux extrémités, ce tube étant sensiblement aligné sur l'ouverture prévue dans le support et fixé sur une seconde face de ce support opposée à ladite première face ou est agencé le capteur. Ainsi, le châssis de l'objectif portant des lentilles de focalisation est fixé directement sur un support ayant la rigidité nécessaire et formant un élément intermédiaire entre ce châssis et le capteur lui-même. On remarque ainsi que le même support sert à la fixation et au maintien de l'objectif et du capteur agencés respectivement d'un côté et de l'autre de ce support.

L'appareil selon l'invention présente une hauteur minimale et une bonne rigidité. Le capteur et ses connexions électriques qui forment la partie fragile de cet appareil sont correctement protégés et ne sont pas soumis à des contraintes mécaniques comme dans l'art antérieur. De plus, les connexions électriques du capteur aux unités électroniques périphériques sont établies sans fils de soudure alors que les plages de connexion du capteur sont pourtant situées du côté de la surface photosensible où sont agencées les diverses métallisations formant les pixels. Le substrat dans lequel est formé le capteur ne doit donc pas être perforé pour l'agencement de vias formés d'un matériau conducteur.

La présente invention sera décrite ci-après en détail à l'aide de la description suivante, faite en référence aux dessins annexés, donnés à titre d'exemple nullement limitatif et dans lesquels :
- la figure 1 représente schématiquement un mode de réalisation d'un appareil de prise d'images selon l'invention;
- la figure 2 représente une variante de réalisation de l'appareil de la figure 1.

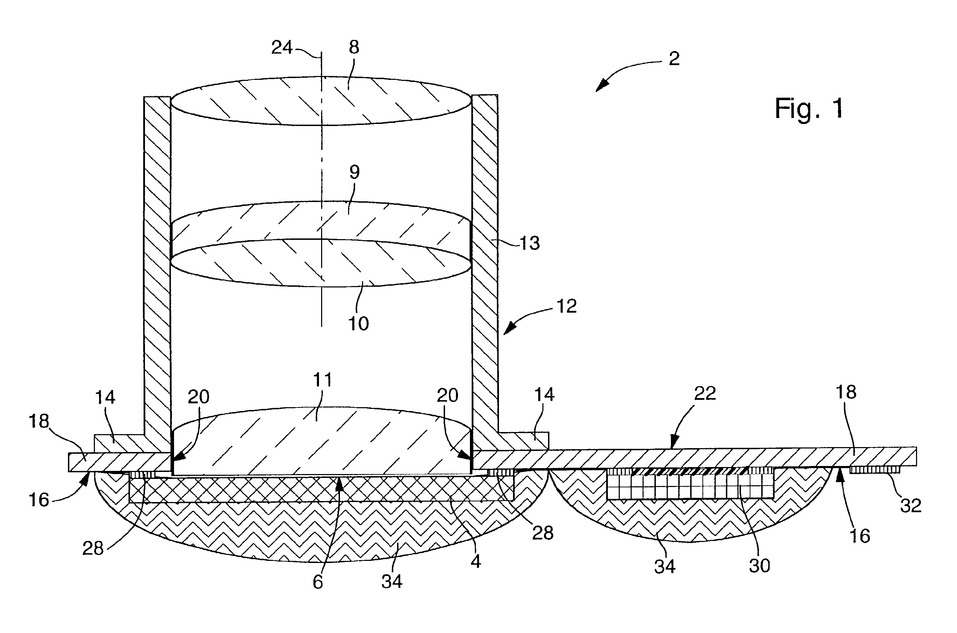

Sur la figure 1 est représenté schématiquement un appareil de prise d'images 2 formant un module compact et autonome. Cependant, il est destiné à être intégré dans un dispositif portable, notamment un téléphone ou un objet portable au poignet comme une montre. Cet appareil est formé d'un capteur d'images 4 présentant une surface photosensible 6 et d'un objectif comprenant des lentilles de focalisation 8, 9, 10 et 11 au moins partiellement montées dans un châssis 12 définissant un tube 13 ouvert à ses deux extrémités et un flasque 14 situé au niveau de l'extrémité interne du tube, c'est-à-dire du côté du capteur. Selon l'invention, le capteur 4 est monté sur la face inférieure 16 d'un support 18 qui présente une ouverture 20 aux dimensions sensiblement égales ou supérieures à celles de la surface photosensible 6 qui est située en regard de l'ouverture 20 de manière sensiblement centrée sur cette dernière. Plus précisément, le flasque 14 est fixé à la face supérieure 22 du support 18 de manière que l'axe optique 24 des lentilles 8 à 11 passe sensiblement par le centre géométrique de l'ouverture et de la surface photosensible.

On notera que certaines lentilles peuvent également avoir une fonction de filtre infrarouge ou ultraviolet, en particulier la lentille 11. Dans une variante de réalisation, l'élément optique 11 est formé seulement par un filtre présentant deux faces parallèles plates. On notera ici que la lentille 11 ou, dans la variante susmentionnée, le filtre peut être fixé(e) soit au châssis 12 de l'objectif, soit au substrat 18 en étant par exemple simplement chassé dans l'ouverture 20, soit encore être fixé directement au capteur 4. Ces diverses possibilités permettent des variantes de réalisation à choix pour l'homme du métier. En particulier, lorsque l'élément optique 11 est fixé, notamment par collage au capteur ou au châssis, il peut présenter des dimensions inférieures à celles de l'ouverture 20. Par contre, lorsque cet élément 11 est fixé soit au capteur, soit au support 18, le tube 13 peut présenter des dimensions internes supérieures à celles de l'ouverture 20 et permettre ainsi de réduire les dimensions de cette ouverture 20 et donc du capteur 4 dont le substrat présente au moins une dimension supérieure à celle de l'ouverture 20.

Lorsque l'élément 11 est fixé directement au capteur 4, cet élément peut permettre de positionner ce capteur lors de son montage avec le substrat 18. De plus, dans ce cas et également lorsque l'élément 11 est maintenu par le substrat lui-même, cet élément peut servir au positionnement du châssis 12. Ainsi, l'homme du métier peut réaliser diverses variantes dans le cadre de la présente invention et définir les dimensions des divers éléments intervenants pour obtenir une prise d'images optimale tout en ayant un appareil aux petites dimensions qui est compact et rigide. On notera encore que le châssis 12 est représenté ici de manière schématique et qu'il peut présenter diverses formes et en particulier avoir un profil interne ou externe non rectiligne.

Le châssis 12 peut être fixé au substrat 18 de diverses manières à disposition de l'homme du métier, notamment par collage. Divers moyens de positionnement peuvent être prévus, en particulier des goupilles agencées dans le substrat ou dans le flasque. Le châssis peut aussi être monté par vissage ou autres moyens équivalents.

Le capteur 4 est formé d'un substrat semiconducteur à la surface duquel sont agencés des pixels définissant la surface photosensible 6. Ces pixels sont reliés par des pistes électriques à des plots 28 de contact électrique avec des plages correspondantes agencées à la surface inférieure 16 du support. A cette surface 16 sont agencées diverses pistes conductrices reliant les plages de contact au capteur 4 avec au moins une unité électronique 30 agencée sur cette face 16. Des plages de contact périphériques 32 peuvent également être prévues pour fournir les images traitées ou partiellement traitées à des moyens d'exploitation, notamment des moyens d'affichage des images prises par l'appareil 2.

Le capteur 4 et l'unité électronique 30 sont protégés au moyen d'une résine 34. Cette résine 34 rigidifie également la partie arrière du substrat 18 et assure le maintien des liaisons électriques entre les plages de contact agencées sur le substrat 18 et les plages ou plots de connexion 28 du capteur. On notera en effet que le capteur 4 peut ne présenter que des plages de contact formées d'une fine métallisation en surface, la connexion électrique étant réalisée au moyen d'une colle conductrice anisotrope ou d'un autre moyen intermédiaire connu de l'homme du métier.

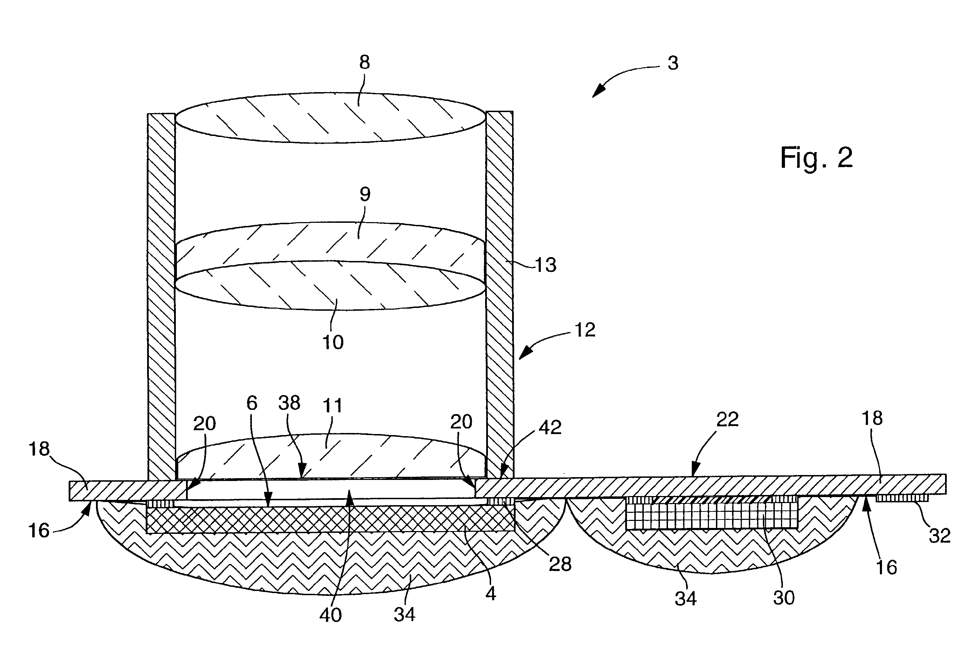

A la figure 2 est représenté une variante de réalisation de l'invention. Les références déjà décrites en détail ci-avant ne le seront pas à nouveau ici.

L'appareil de prise d'images 3 se distingue essentiellement de celui de la figure 1 par le fait que l'objectif porte l'ensemble des lentilles et que l'élément optique interne 11 ne pénètre pas l'ouverture 20 du substrat 18. Dans l'exemple représenté à la figure 2, l'élément optique 11 présente une surface plate 38 fermant le châssis 12 à son extrémité interne 40. La surface 38 est donc agencée soit au niveau de la surface d'extrémité 42 du cylindre 13, soit en retrait à l'intérieur de celui-ci de sorte qu'elle ne dépasse pas cette surface 42.

De ce fait, les dimensions de l'objectif, en particulier du châssis 12 peuvent être définies indépendamment des dimensions de l'ouverture 20 du substrat 18 et du capteur 4. Ceci peut permettre notamment de limiter au mieux la surface photosensible nécessaire et les dimensions du substrat semiconducteur formant le capteur 4. En effet, les dimensions de l'ouverture 20 peuvent être inférieures à celles de l'élément optique 11 ou des dimensions géométriques de l'ouverture du châssis 12 à l'extrémité interne 40. Dans ce cas, les rayons lumineux subissant dans les bords des lentilles des aberrations importantes peuvent être aisément non-captés par la surface photosensible 6 sans devoir pour autant prévoir un substrat aux dimensions inutilement grandes pour le capteur 4.

On notera finalement que le support 18 peut avantageusement avoir une partie souple pliable entre une première partie supportant le capteur et l'objectif et une deuxième partie supportant d'autres unités, notamment l'unité électronique 30. Ceci permet de rabattre la deuxième partie sous la première partie pour obtenir un appareil très compact où l'unité 30 est notamment située en regard du capteur 4, dans le prolongement de l'objectif.

## Revendications

1. Appareil de prise d'images (2; 3) de petites dimensions formé d'au moins une lentille optique (8, 9, 10) et d'un capteur (4) présentant une surface photosensible (6) sensiblement centrée sur l'axe optique (24) de ladite lentille, **caractérisé en ce que** ledit capteur est monté à une première face (16) d'un support (18) qui présente une ouverture (20), ladite surface photosensible étant située en regard de cette ouverture, ladite lentille étant agencée du côté dudit support qui est opposé à ladite première face.

2. Appareil selon la revendication 1, **caractérisé en ce que** ledit support (18) comprend des pistes conductrices et des premières plages de contact électrique, ledit capteur (4) comprenant des deuxièmes plages de contact ou plots (28) agencé(e)s du côté de la surface photosensible (6) et relié(e)s électriquement à desdites plages de contact correspondantes dudit support.

3. Appareil selon la revendication 1 ou 2, **caractérisé en ce que** ledit capteur est intégré dans un substrat semiconducteur à une face duquel sont agencées ladite surface photosensible et lesdites deuxièmes plages de contact ou plots de ce capteur.

4. Appareil selon l'une des revendications précédentes, **caractérisé en ce que** ladite au moins une lentille (8, 9, 10) est agencée dans un châssis (12) formant sensiblement un tube (13) ouvert à ses deux extrémités, ce tube étant sensiblement aligné sur ladite ouverture (20) dudit support et fixé à une seconde face (22) de ce support opposée à ladite première face (16).

5. Appareil selon la revendication 1, **caractérisé en ce qu'**il est prévu un élément optique (11) formant une deuxième lentille, un filtre ou une lentille-filtre qui ferme ledit châssis (12) à son extrémité interne (40), cet élément optique définissant une surface externe (38) ne sortant pas dudit châssis.

6. Appareil selon la revendication 4, **caractérisé en ce qu'**il est prévu un élément optique (11) formé d'une deuxième lentille, un filtre ou une lentille-filtre qui pénètre au moins partiellement dans ladite ouverture dudit support.

7. Appareil selon la revendication 6, **caractérisé en ce que** ledit élément optique (11) est fixé audit support (18) et/ou audit capteur (4).

8. Appareil selon l'une des revendications précédentes, **caractérisé en ce qu'**il est prévu au moins une unité électronique (30) de traitement et/ou d'exploitation des signaux électriques fournis par ledit capteur, cette unité électronique étant agencée sur ladite première face (16) dudit support (18).

9. Appareil selon l'une des revendications précédentes, **caractérisé en ce que** ledit capteur est protégé par une résine (34) déposée sur celui-ci et sur ladite première face dudit support.

10. Appareil selon l'une des revendications précédentes, **caractérisé en ce que** ledit support (18) comprend des plages de contact électrique (32) permettant de relier cet appareil à d'autres unités électroniques et/ou moyens d'affichage d'images agencé(e)s dans un dispositif, notamment un téléphone portable ou une montre, dans lequel il est également prévu d'agencer cet appareil.
